# EUROPEAN PATENT SPECIFICATION

(11) **EP 3 913 633 B1**
(45) Date of publication and mention of the grant of the patent: **25.11.2026**
(21) Application number: 21159792.7
(22) Date of filing: 07.02.2014
(51) Int. Cl.: G11C 29/12, G06F 11/27, G01R 31/3187, G11C 17/16

(54) **OPTIMIZING FUSEROM USAGE FOR MEMORY REPAIR**
OPTIMIERUNG DER FUSEROM-VERWENDUNG ZUR SPEICHERREPARATUR
OPTIMISATION D'UTILISATION DE FUSEROM POUR RÉPARATIONS DE MÉMOIRE

(30) Priority: 07.02.2013 IN 528CH2013; 26.09.2013 US 201314038306
(43) Date of publication of application: 24.11.2021
(62) Document number(s) of the earlier application(s) in accordance with Art. 76 EPC: 14749339.9 / 2 994 915
(73) Proprietor: Texas Instruments Incorporated, Dallas, TX 75265-5474 (US)
(72) Inventor: VARADARAJAN, Devanathan, 560078 Bangalore (IN); ELLUR, Harsharaj, 560001 Bangalore (IN)
(74) Representative: Zeller, Andreas

(56) References cited:
- US-A1- 2003 237 033
- US-A1- 2007 258 296
- US-A1- 2013 031 319
- US-B1- 6 363 020
- US-B2- 7 757 135

## Description

This relates generally to integrated circuits and more particularly to reducing the area required for repairing plurality of memories on an integrated circuit.

### BACKGROUND

Integrated circuits (ICs) generally include various modules combined to perform various functions. For example, a digital signal processor (DSP) includes processor and memory blocks embedded in the IC. The memory blocks containing plurality of addressable memory locations are tested for defects, ensuring the operability of the IC. To test these blocks, special test circuits, referred to as "Built-In Self Test" (BIST) circuits are incorporated into the IC. BIST circuits generate a test pattern to determine whether the memory block is defective or not. In some cases the circuit provides redundant rows and/or columns that are used to repair defective rows and columns in the memory block.

Electronic fuse or Efuse or fuseROM is also used for memory repair. fuseROM store a repair data or repair signature that identifies a defective element in the memory block. A repair signature for all the memory blocks under test is stored in the fuseROM. The repair signature is used for repair of the memory blocks. In a system with many memories, the size of the fuseROM is directly related to the sum of the number of memory blocks under test.

With increasing memories in today's SoCs (System-on-chip), memory repair has become crucial to improve yield in low process technologies such as 45nm and below. It has been observed across multiple SoCs, that fuseROM area is increasingly becoming an area bottleneck, partly due to the fact that fuseROM utilization is very poor even after memory repair. The repair data load time (autoload time) is a time required to load the repair data from the fuseROM to the plurality of memory blocks. Additionally, for devices where wakeup time is crucial, the repair data load time (autoload time) forms a significant portion of the overall boot time or activation time.

Thus, there is a need to efficiently test memories without requiring an enormous fuseROM area, with low autoload time and without compromising on memory reparability or test quality. US 6 363 020 B1 discloses a semiconductor memory architecture for embedded memory instances having redundancy. A fuse box register is provided outside the memory macro associated with the memory instances. The memory instances are daisy-chained to the fuse box register containing a plurality of fuses used for storing fuse data associated with the defective rows and columns of main memory. Further, US 2007/258296 A1 discloses a method of repairing an integrated circuit of the type comprising of a multitude of memory arrays and a fuse box holding control data for controlling redundancy logic of the arrays.

### SUMMARY

The present invention is defined in independent circuit claim 1 and independent method claim 6. Selected optional features are recited in the dependent claims.

Only embodiments or examples comprising all features of independent device claim 1 and independent method claim 6 fall under the scope of protection of the present invention, while the remaining ones correspond to illustrative examples which are useful for the understanding of the relevant technical context.

An embodiment provides an integrated circuit that includes a plurality of memory wrappers. Each memory wrapper includes a memory block with a fuse register and a bypass register. The bypass register have a bypass data that indicates a defective memory wrapper of the plurality of memory wrappers. A fuseROM controller is coupled to the plurality of memory wrappers. A memory bypass chain links the bypass registers in the plurality of memory wrappers with the fuseROM controller. The fuseROM controller loads the bypass data in the memory bypass chain. A memory data chain links the fuse registers in the plurality of memory wrappers with the fuseROM controller. The memory data chain is re-configured to link the fuse registers in a set of defective memory wrappers of the plurality of memory wrappers responsive to the bypass data loaded in the memory bypass chain.

An example embodiment provides an integrated circuit that includes a plurality of memory wrappers. Each memory wrapper comprises a memory block with a fuse register and a bypass register. The bypass register have a bypass data that indicates a defective memory wrapper of the plurality of memory wrappers. A BISR (built-in self-repair) controller is coupled to each memory wrapper of the plurality of memory wrappers. The BISR controller self repairs each memory wrapper. A fuseROM controller is coupled to the BISR controller and to the plurality of memory wrappers. A fuseROM is coupled to the fuseROM controller. The fuseROM includes a memory data storage that stores a repair data corresponding to each defective memory wrapper and a memory bypass storage that stores the bypass data corresponding to each memory wrapper. A memory bypass chain links the bypass registers in the plurality of memory wrappers with the fuseROM controller. The fuseROM controller loads the bypass data in the memory bypass chain. A memory data chain is configured to link the fuse registers in the plurality of memory wrappers with the fuseROM controller. The memory data chain is re-configured to link the fuse registers in a set of defective memory wrappers of the plurality of memory wrappers responsive to the bypass data loaded in the memory bypass chain.

An embodiment provides a method of repairing one or more memory wrappers on an integrated circuit. A bypass data corresponding to each memory wrapper of the one or more memory wrappers is stored in a memory bypass storage. The bypass data is configured to indicate a defective memory wrapper of the one or more memory wrappers. A repair data corresponding to each defective memory wrapper is stored in a memory data storage. The bypass data is loaded in a memory bypass chain. The memory bypass chain links the bypass register of each memory wrapper of the one or more memory wrappers. The repair data is loaded in a memory data chain that links each defective memory wrapper of the one or more memory wrappers.

Another embodiment provides a method of self repairing one or more memory wrappers on an integrated circuit. A bypass data is generated for each memory wrapper of the one or more memory wrappers. The bypass data indicates a defective memory wrapper. A repair data is generated for each defective memory wrapper of the one or more memory wrappers. One or more fuses of a fuseROM are blown to store the repair data corresponding to each defective memory wrapper in a memory data storage of the fuseROM. The bypass data corresponding to each memory wrapper is stored in a memory bypass storage of the fuseROM. The bypass data is loaded in a bypass register of each memory wrapper of the one or more memory wrappers. The repair data is loaded in a memory data chain configured to link each defective memory wrapper of the one or more memory wrappers.

An example embodiment provides a method of incremental repairing one or more memory wrappers on an integrated circuit. A bypass data corresponding to each memory wrapper of the one or more memory wrapper is stored in a memory bypass storage. The bypass data indicates a defective memory wrapper. A repair data corresponding to each defective memory wrapper is stored in a memory data storage. The bypass data is loaded in a bypass register of each memory wrapper of the one or more memory wrappers. The repair data is loaded in a memory data chain configured to link each defective memory wrapper of the one or more memory wrappers. The one or more memory wrappers are tested to identify one or more new defective memory wrappers. A bypass data corresponding to each memory wrapper of the one or more memory wrapper is stored in a new memory bypass storage. The bypass data indicates if a memory wrapper is defective. A repair data corresponding to each new defective memory wrapper of the one or more new defective memory wrappers is stored in a new memory data storage. The bypass data is loaded in the bypass register of each memory wrapper of the one or more memory wrappers. The repair data is loaded in a memory data chain configured to link each new defective memory wrapper of the one or more memory wrappers

### BRIEF DESCRIPTION OF THE DRAWINGS

FIG.1 illustrates a block diagram of a memory repair system in an integrated circuit (IC), according to an embodiment;
FIG. 2(a) illustrates a block diagram of a memory repair system in an integrated circuit (IC), according to an embodiment;
FIG. 2(b) illustrates the new defective memory wrappers after the testing phase, according to an embodiment;
FIG. 3 illustrates a block diagram of a memory repair system in an integrated circuit (IC), according to an embodiment; and
FIG.4 is a flow diagram illustrating a memory repair system for testing one or more memory wrappers on an integrated circuit, according to an embodiment.

### DETAILED DESCRIPTION OF EXAMPLE EMBODIMENTS

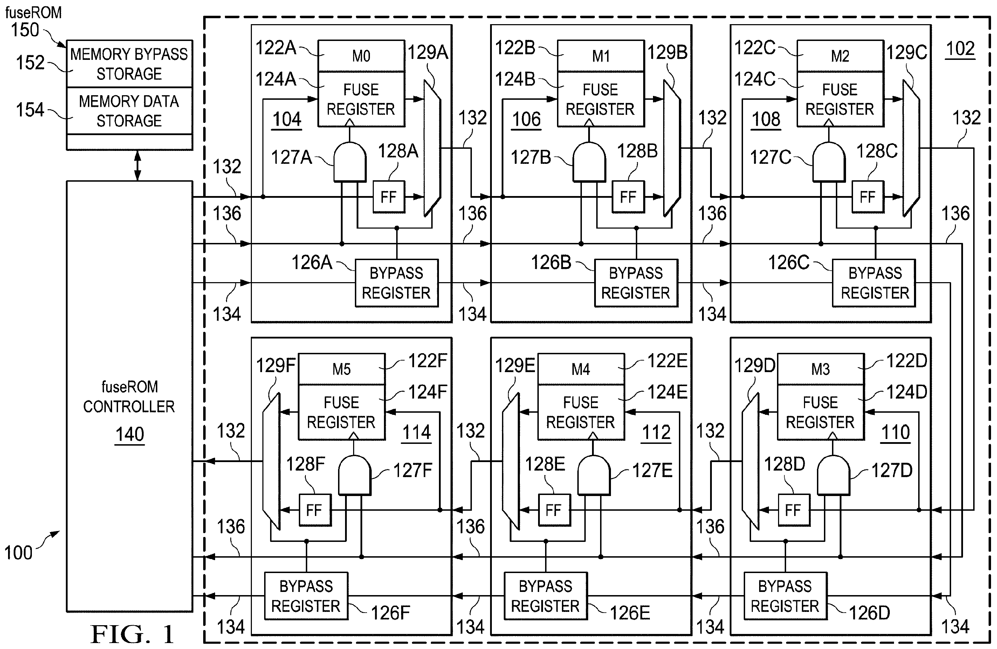

FIG.1 illustrates a block diagram of a memory repair system in an integrated circuit (IC) 100, according to an embodiment. The IC 100 includes a plurality of memory wrappers 102, for example memory wrapper 104, 106, 108, 110, 112 and 114. Each memory wrapper includes a memory block e.g. memory blocks M0 122A, M1 122B, M2 122C, M3 122D, M4 122E and M5 122F. As illustrated, the memory wrapper 104 includes a memory block M0 122A and memory wrapper 106 includes a memory block M1 122B. In another embodiment, each memory wrapper includes a plurality of memory blocks. Each memory block has a fuse register e.g. fuse register 124A, 124B, 124C, 124D, 124E and 124F. Each memory wrapper also includes a bypass register e.g. bypass register 126A, 126B, 126C, 126D, 126E and 126F. Each memory wrapper includes a clock-gate e.g. clock-gate 127A, 127B, 127C, 127D, 127E and 127F. The clock-gate 127A receives an output of the bypass register 126A and a memory clock 136. The fuse register 124A receives the memory clock 136 through the clock-gate 127A. Each memory wrapper includes a flip-flop e.g. flip-flop 128A, 128B, 128C, 128D, 128E and 128F. Each memory wrapper includes a multiplexer e.g. multiplexer 129A, 129B, 129C, 129D, 129E and 129F. The multiplexer 129A receives an output of the flip-flop 128A and an output of the fuse register 124A. The multiplexer 129A is configured to generate an output signal in response to an output of the bypass register 126A. A fuseROM controller 140 is coupled to the plurality of memory wrappers 102. In one embodiment, the fuseROM controller 140 is coupled to one or more memory wrappers. A memory data chain 132 links the fuseROM controller 140 to the fuse registers 124A, 124B, 124C, 124D, 124E and 124F in the plurality of memory wrappers 102. The memory data chain 132 also serves as an input to the flip-flops 128A, 128B, 128C, 128D, 128E and 128F. A memory bypass chain 134 is configured to link the fuseROM controller 140 to the bypass registers 126A, 126B, 126C, 126D, 126E and 126F in the plurality of memory wrappers 102. The memory clock 136 from the fuseROM controller 140 is provided to the clock-gate 127A, 127B, 127C, 127D, 127E and 127F in the plurality of memory wrappers 102. A fuseROM 150 is coupled to the fuseROM controller 140. The fuseROM includes a memory bypass storage 152 and a memory data storage 154. Additionally, embodiments including the IC 100 with a single memory wrapper are contemplated. The IC 100 may include one or more additional components known to those skilled in the relevant art and are not discussed here for simplicity of the description.

The integrated circuit 100 is designed for any desired function, and includes circuitry and the plurality of memory blocks M0-M5 to implement that function. In one embodiment, the memory blocks M0-M5 are caches implemented in a microprocessor or other arrays implemented in the microprocessor (e.g. translation lookaside buffers etc.). In an alternative embodiment, the integrated circuit 100 includes one or more processors and supporting circuitry (e.g. the fuseROM controller 140) in an integrated processor configuration (e.g. a microcontroller or embedded processor). In such an implementation, the memory blocks M0-M5 include caches or other memories for the processor, memories for the supporting circuitry, etc. In another embodiment, one or more processors and one or more peripheral circuits (e.g. I/O interface circuits or integrated I/O peripherals) are included in an SOC configuration. The memory blocks M0-M5 would then include caches or other memories for the processor, memories for the peripheral circuits, etc. In an embodiment, the integrated circuit 100 includes no processors and is a fixed-function integrated circuit such as an application specific integrated circuit (ASIC). The memory blocks M0-M5in this case are arrays used by the fixed-function circuitry. Generally, as used herein, a memory is any storage implemented on an integrated circuit. For example, memory includes SRAM, DRAM, DDR memory, SDRAM, etc. In an embodiment, the memory blocks M0-M5 are different from each other i.e. for example memory blocks M0-M2 are SRAM memories and memory blocks M3-M5 are DDR memories.

Each memory wrapper of the plurality of memory wrappers 102 is similar in connections and operation. Therefore, the operation of memory wrapper 104 is explained now and the operation of the other memory wrappers is not discussed here for simplicity of the description.

The memory wrapper 104 includes a clock-gate 127A that receives the memory clock 136. The memory clock 136 is used to clock the fuse register 124A. The memory bypass chain 134 links the fuseROM controller 140 to the bypass register 126A. The memory bypass storage 152 stores a bypass data corresponding to each memory wrapper of the plurality of memory wrappers 102. The memory bypass storage 152 stores a bypass data corresponding to the memory wrapper 104. The fuseROM controller 140 loads the bypass data from the memory bypass storage 152 in the bypass register 126A. The bypass data in the bypass register 126A indicates if the memory wrapper 104 is defective. The memory data chain 132 links the fuseROM controller 140 to the fuse register 124A. The memory data storage 154 stores a repair data corresponding to each defective memory wrapper. The memory data storage 154 stores a repair data corresponding to the memory wrapper 104 if the bypass data in the bypass register 126A indicates that the memory wrapper 104 is defective. When the bypass data in the bypass register 126A is equal to an index value, the memory wrapper 104 is defective. The bypass data in the bypass register 126A is compared with the index value to identify a defective memory wrapper. In one embodiment, the index value is a set of bits predefined in the IC 100. The clock-gate 127A provides a memory clock 136 to the fuse register 124A when the bypass data in the bypass register 126A is equal to the index value. The repair data on the memory data chain 132 is provided to the fuse register 124A. The fuse register 124A generates a fuse register signal which is provided to the multiplexer 129A.

The repair data on the memory data chain 132 is provided to the flip-flop 128A that generates a flip-flop signal. The flip-flop signal is the same as the repair data on the memory data chain 132 as the function of the flip-flop 128A is just to add delay to the repair data by a predefined time period. The flip-flop 128A provides ease of timing closure to the memory repair system illustrated in Fig. 1. The flip-flop 128A provides an ability to absorb the process variation margins introduced in the integrated circuit 100 without significant additional costs. In one embodiment, the memory wrappers 104-114 in the integrated circuit 100 are implemented without flip-flops. The multiplexer 129A receives the flip-flop signal from the flip-flop 128A and a fuse register signal from the fuse register 124A. The multiplexer 129A generates an output signal in response to the bypass data in the bypass register 126A. When the bypass data in the bypass register 126A is equal to the index value i.e. when the memory wrapper 104 is defective, the output signal of the multiplexer 129A is the fuse register signal. When the bypass data in the bypass register 126A is not equal to the index value i.e. the memory wrapper 104 is non-defective, the clock-gate 127A is inactivated. As a result, the memory clock 136 is not provided to the fuse register 124A, thus inactivating the fuse register 124A. In this case, the output signal of the multiplexer 129A is the flip-flop signal or the repair data on the memory data chain 132. Thus, when the memory wrapper 104 is non-defective, the repair data on the memory data chain 132 is directly sent as the output signal thus bypassing the fuse register 124A in the memory wrapper 104. This reduces the activation time of the integrated circuit 100 as the memory wrappers that are non-defective are kept out of the memory data chain 132 used for repairing the plurality of memory wrappers 102. The output signal of the multiplexer 129A is provided on the memory data chain 132. Thus, when the fuseROM controller 140 loads the repair data on the memory data chain 132, the repair data is shifted on the memory data chain 132 to be loaded in the fuse register of each defective memory wrapper whereas the fuse register of each non-defective memory wrapper is bypassed. The flip-flop 128A prevents combinational feed-through path from the input point of memory data chain 132 in the memory wrapper 104 to the point of output signal generation in the memory wrapper 104.

The operation of the circuit illustrated in FIG. 1 is explained now. Initially, the memory repair system in an integrated circuit (IC) 100 is reset. The memory bypass storage 152 stores a bypass data corresponding to each memory wrapper of the plurality of memory wrappers 102. The fuseROM controller 140 loads the bypass data in the memory bypass chain 134. The bypass data indicates a defective memory wrapper. The fuseROM controller 140 loads the bypass data stored in the memory bypass storage 152 in the corresponding bypass register of each memory wrapper. In one embodiment, the size of bypass register is one bit. In one embodiment, the fuseROM controller 140 maintains a look-up table of bypass data location in the memory bypass storage 152 corresponding to the bypass register in each of the plurality of memory wrappers 102. The memory data storage 154 stores a repair data corresponding to each defective memory wrapper. The memory data chain 132 links the fuse registers 124A, 124B, 124C, 124D, 124E and 124F in the plurality of memory wrappers 102 with the fuseROM controller 140. The memory data chain 132 is re-configured to link the fuse registers in a set of defective memory wrappers responsive to the bypass data loaded in the memory bypass chain 134. The provision of storing repair data only for the set of defective memory wrappers allows reduction in fuseROM 150 area required for memory repair.

The memory data chain 132 is connected to the fuse registers 124A, 124B, 124C, 124D, 124E and 124F in a daisy chain fashion. Similarly, the memory bypass chain 134 is connected to the bypass registers 126A, 126B, 126C, 126D, 126E and 126F in a daisy chain fashion. In one embodiment, the memory data chain 132 and the memory bypass chain 134 are connected in one to one fashion with the respective registers. In another embodiment, the memory data chain 132 and the memory bypass chain 134 are connected to the respective registers for optimum performance of the memory repair system on the IC 100. The memory bypass chain 134 and the memory data chain 132 may be multiplexed over a single physical pin of the fuseROM controller 140. In one embodiment, the fuseROM controller 140 reads the memory bypass storage 152 of the fuseROM 150 and shifts the bypass data in the memory bypass chain 134. The bypass data gets loaded in the bypass registers of the respective memory wrappers. Once the entire bypass data is shifted into the bypass registers, the memory data chain is re-configured to link only the set of defective memory wrappers. The repair data corresponding to the set of defective memory wrappers is then shifted in the memory data chain 132 by the fuseROM controller 140. The fact that the memory data chain 132 is re-configured to link only the set of defective memory wrappers allows reduction in activation time of the integrated circuit. The fuseROM controller 140 loads the repair data in the corresponding fuse register of each defective memory wrapper. In one embodiment, the fuseROM controller 140 maintains a lookup-table of repair data location in the memory data storage 154 corresponding to a fuse register in a defective memory wrapper of the set of defective memory wrappers. In one embodiment, the defective memory wrappers are activated in response to the bypass data loaded in the bypass register of each memory wrapper and the memory data chain loads the repair data corresponding to each defective memory wrapper in the fuse registers of the defective memory wrappers. In addition, storing repair data only for the set of defective memory wrappers allows reduction in fuseROM 150 area required for repairing the plurality of memory wrappers 102.

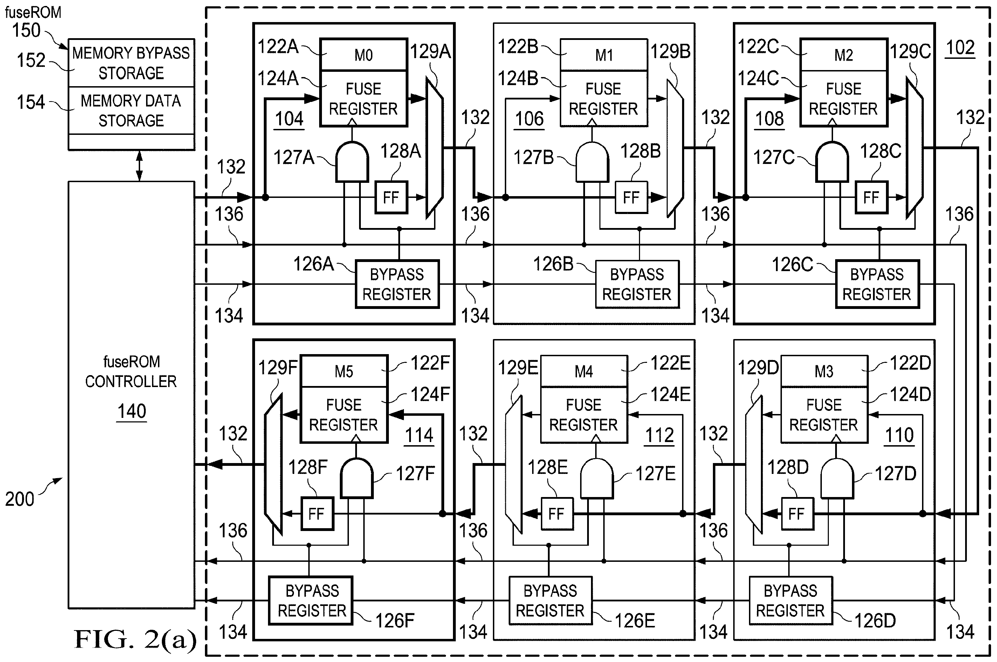

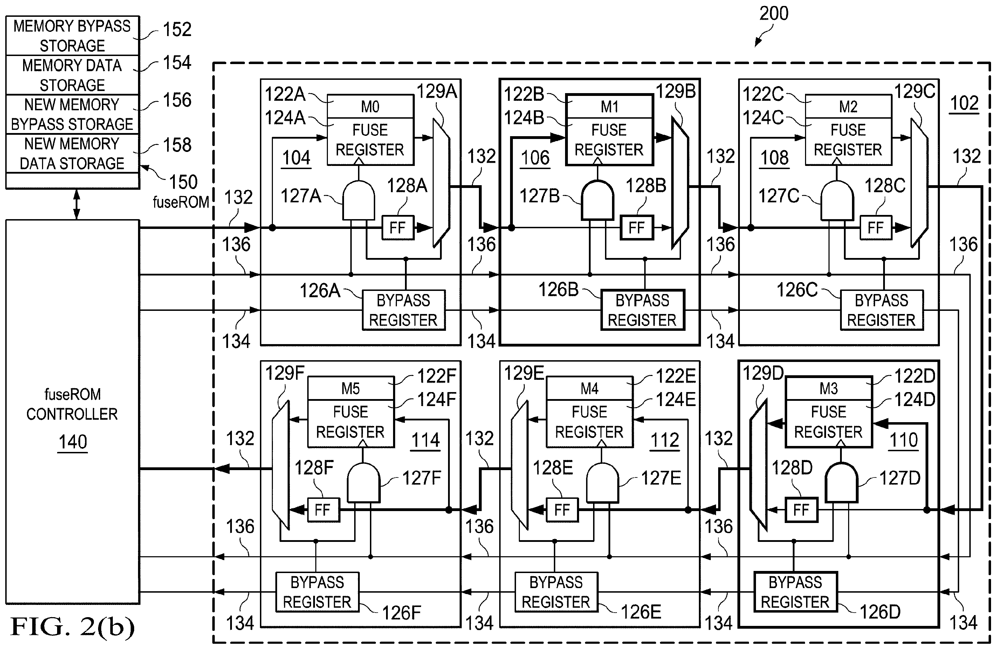

FIG. 2(a) illustrates a block diagram of a memory repair system in an integrated circuit 200, according to an embodiment. The memory repair system in an integrated circuit 200 is similar in connection and operation to the memory repair system in an integrated circuit 100. The components of Fig. 2(a) that have identical reference numerals as those of Fig. 1 have same or similar functionalities as explained with respect to Fig. 1 and are therefore not explained again for brevity reasons. The memory bypass storage 152 stores a bypass data corresponding to each memory wrapper of the plurality of memory wrappers 102. The bypass data indicates a defective memory wrapper. The fuseROM controller 140 loads the bypass data stored in the memory bypass storage 152 in the corresponding bypass register of each memory wrapper. The memory data storage 154 stores a repair data corresponding to each defective memory wrapper. The Fig. 2(a) illustrates a later stage functionality of Fig. 1 in which the bypass data has been loaded in the bypass registers of the plurality of memory wrappers and memory wrapper 104, 108 and 114 are identified as defective. The memory data chain 132 is re-configured to link only the set of defective memory wrappers 104, 108 and 114 as illustrated in Fig. 2(a) with a thick marking. The non-defective memory wrappers 106, 110 and 112 are inactivated by inactivating the clock-gate 127B, 127D and 127E respectively. As a result, the memory clock 136 is not provided to the fuse register 124B, 124D and 124E, thus bypassing the non-defective memory wrappers 106, 110 and 112. The memory data storage 154 stores a repair data corresponding to the defective memory wrappers 104, 108 and 114. The repair data corresponding to the defective memory wrappers 104, 108 and 114 is then shifted in the memory data chain 132 by the fuseROM controller 140. After repairing of the defective memory wrappers 104, 108 and 114, the plurality of memory wrappers are again tested to identify one or more new defective memory wrappers. The testing is performed by an internal BIST (built-in self-test) circuit or by an external testing mechanism through a test interface on the IC 200 (not illustrated in Figures). FIG. 2(b) illustrates that after the testing phase, memory wrappers 106 and 110 are identified as new defective memory wrappers. A bypass data corresponding to each memory wrapper of the one or more memory wrapper is stored in the new memory bypass storage 156 and a repair data corresponding to the new defective memory wrappers 106 and 110 is stored in the new memory data storage 158. The fuseROM controller 140 loads the bypass data stored in the new memory bypass storage 152 in the corresponding bypass register of each memory wrapper of the plurality of memory wrappers 102. The memory data chain 132 is re-configured to link only the set of new defective memory wrappers 106 and 110 as illustrated in Fig. 2(b) with a thick marking. The non-defective memory wrapper 112 and the previously repaired memory wrappers 104, 108 and 114 are inactivated by inactivating the clock-gate 127A, 127C, 127E and 127F respectively. As a result, the memory clock 136 is not provided to the fuse register 124A, 124C, 124E and 124F, thus bypassing the non-defective memory wrapper 112 and the previously repaired memory wrappers 104, 108 and 114. The new memory data storage 158 stores a repair data corresponding to the new defective memory wrappers 106 and 110. The repair data corresponding to the new defective memory wrappers 106 and 110 is then shifted in the memory data chain 132 by the fuseROM controller 140 to perform incremental repair of the new defective memory wrappers 106 and 110.

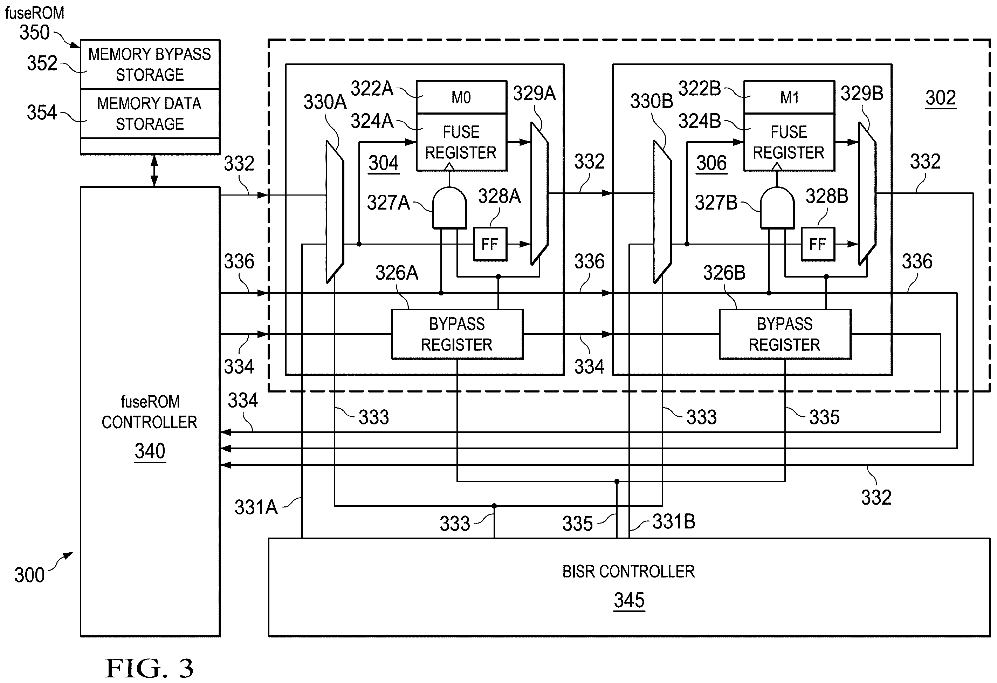

FIG.3 illustrates a block diagram of a memory repair system in an integrated circuit (IC) 300, according to an embodiment. The IC 300 includes a plurality of memory wrappers 302, for example memory wrapper 304 and 306. For illustration purpose and ease of understanding, only two memory wrappers are used for explaining the functionality of memory repair system. Each memory wrapper includes a memory block e.g. memory blocks M0 322A and M1 322B. As illustrated, the memory wrapper 304 includes a memory block M0 322A and memory wrapper 306 includes a memory block M1 322B. In another embodiment, each memory wrapper includes a plurality of memory blocks. Each memory block has a fuse register e.g. fuse register 324A and 324B. Each memory wrapper also includes a bypass register e.g. bypass register 326A and 326B. Each memory wrapper includes a clock-gate e.g. clock-gate 327A and 327B. The clock-gate 327A receives an output of the bypass register 326A and a memory clock 336 form the fuseROM controller 340. The fuse register 324A receives the memory clock 336 through the clock-gate 327A. A BISR (built-in self-repair) controller 345 is coupled to each memory wrapper of the plurality of memory wrappers 302. As illustrated, the BISR controller 345 is coupled to the memory wrapper 304 and memory wrapper 306. In one embodiment, the BISR controller 345 is coupled to a set of memory wrappers. Each memory wrapper includes a first multiplexer e.g. multiplexer 330A and 330B. The first multiplexer 330A receives a repair data on the memory data chain 332 and a repair data on repair load chain 331A. The first multiplexer generates a first mux output in response to a BISR (built-in self-repair) selection signal 333 received from the BISR controller 345. Each memory wrapper includes a flip-flop e.g. flip-flop 328A and 328B.

Each memory wrapper includes a second multiplexer e.g. multiplexer 329A and 329B. The second multiplexer 329A receives an output of the flip-flop 328A and an output of the fuse register 324A. The second multiplexer 329A is configured to generate an output signal in response to an output of the bypass register 326A. A memory data chain 332 links the fuseROM controller 340 to the fuse registers 324A and 324B in the plurality of memory wrappers 302. The memory data chain 332 serves as an input to the first multiplexers 330A and 330B. A memory bypass chain 334 is configured to link the fuseROM controller 340 to the bypass registers 326A and 326B in the plurality of memory wrappers 302. The memory clock 336 is provided to the clock-gates 327A and 327B in the plurality of memory wrappers 302. A fuseROM 350 is coupled to the fuseROM controller 340. The fuseROM 350 includes a memory bypass storage 352 and a memory data storage 354. Additionally, embodiments including the integrated circuit 300 with a single memory wrapper are contemplated. The integrated circuit 300 may include one or more additional components known to those skilled in the relevant art and are not discussed here for simplicity of the description.

The integrated circuit 300 is designed for any desired function, and includes circuitry and the plurality of memory blocks M0-M1 to implement that function. In one embodiment, the memory blocks M0-M1 are caches implemented in a microprocessor or other arrays implemented in the microprocessor (e.g. translation lookaside buffers etc.). In an alternative embodiment, the integrated circuit 300 includes one or more processors and supporting circuitry (e.g. the fuseROM controller 340) in an integrated processor configuration (e.g. a microcontroller or embedded processor). In such an implementation, the memory blocks MO-M1 include caches or other memories for the processor, memories for the supporting circuitry, etc. In another embodiment, one or more processors and one or more peripheral circuits (e.g. I/O interface circuits or integrated I/O peripherals) are included in an SOC configuration. The memory blocks M0-M1 would then include caches or other memories for the processor, memories for the peripheral circuits, etc. In an embodiment, the integrated circuit 300 includes no processors and is a fixed-function integrated circuit such as an application specific integrated circuit (ASIC). The memory blocks M0-M1 in this case are arrays used by the fixed-function circuitry. Generally, as used herein, a memory is any storage implemented on an integrated circuit. For example, memory includes SRAM, DRAM, DDR memory, SDRAM, etc. In an embodiment, the memory blocks M0-M1 are different from each other i.e. for example memory block M0 is SRAM memory and memory blocks M1 is DDR memory.

The BISR controller 345 performs self-repair of the plurality of memory wrappers 302. The BISR controller 345 is configured to generate a bypass data for each memory wrapper of the plurality of memory wrappers 302 and store the bypass data in the corresponding bypass register of each memory wrapper. For example, the bypass data generated by the BISR controller 345 is stored in the bypass registers 326A and 326B. The bypass data indicates if a memory wrapper is defective. The BISR controller 345 generates a repair data corresponding to each defective memory wrapper of the plurality of memory wrappers 302 and stores the repair data in the corresponding fuse register of the defective memory wrapper. For example, if the bypass data indicates that the memory wrapper 304 is non-defective and the memory wrapper 306 is defective, then the BISR controller 345 generates repair data only for defective memory wrapper 306 and stores in the fuse register 324B. The BISR controller 345 generates the bypass data and the repair data for the memory wrapper 304 before generating the bypass data and the repair data for the memory wrapper 306. In one embodiment, the BISR controller 345 generates the bypass data and the repair data for a set of memory wrappers. The BISR controller 345 activates the fuseROM controller 340 to blow one or more fuses of the fuseROM 350 to store the repair data corresponding to each defective memory wrapper in the memory data storage 354 of the fuseROM 350. The fuseROM controller 340 copies the repair data from the fuse registers of the defective memory wrappers to the memory data storage 354 and erases the fuse registers. For example, when the memory wrapper 306 is defective, the fuseROM controller 340 copies the repair data from the fuse register 324B to the memory data storage 354 and erases the fuse register 324B. The BISR controller 345 activates the fuseROM controller 340 to store the bypass data corresponding to each memory wrapper in the memory bypass storage 352 of the fuseROM 350. The fuseROM controller 340 copies the bypass data from the bypass registers of each memory wrapper to the memory bypass storage 352 and erases the bypass registers. For example, the fuseROM controller 340 copies the bypass data from the bypass registers 326A and 326B to the memory bypass storage 352 and erase the bypass registers 326A and 326B.

To further illustrate the functioning of the memory repair system on integrated circuit 300, the functioning at memory wrapper level is explained now. Each memory wrapper of the plurality of memory wrappers 302 is similar in connections and operation. Therefore, the operation of memory wrapper 304 is explained now and the operation of the other memory wrappers is not discussed here for simplicity of the description.

On activation of the integrated circuit 300, the BISR controller 345 performs self repair of the plurality of memory wrappers 302. The BISR controller 345 is configured to generate a bypass data for the memory wrapper 304. The BISR controller 345 stores the bypass data in the bypass register 326A through the bypass load chain 335. The bypass data in the bypass register 326A indicates if the memory wrapper 304 is defective. If the memory wrapper 304 is defective, the BISR controller 345 generates a repair data for the memory wrapper 304. Otherwise, if the memory wrapper 304 is non-defective, the BISR controller 345 self repair the next memory wrapper i.e. memory wrapper 306. When the memory wrapper 304 is defective, the BISR controller 345 generates a repair data for the memory wrapper 304. The BISR controller 345 activates a BISR selection signal 333 to a first multiplexer 330A. The memory wrapper 304 includes a clock-gate 327A that receives the memory clock 336. The memory clock 336 is used to clock the fuse register 324A in response to the bypass data in the bypass register 326A. The clock-gate 327A is activated to provide memory clock 336 to the fuse register 324A when the bypass data in the bypass register indicates that the memory wrapper 304 is defective. When the bypass data in the bypass register 326A is equal to an index value, the memory wrapper 304 is defective. The bypass data in the bypass register 326A is compared with the index value to identify a defective memory wrapper. In one embodiment, the index value is a set of bits predefined in the IC 300. In response to the BISR selection signal 333, the first multiplexer 330A generates a first mux output which is the repair data on the repair load chain 331A from the BISR controller 345. The repair data is then stored in the fuse register 324A. The second multiplexer 329A is inactivated when the repair data is stored in the fuse register 324A. After generating the bypass data for each memory wrapper and the repair data for each defective memory in the plurality of memory wrappers 302, the BISR controller 345 activates the fuseROM controller 340 to blow one or more fuses of the fuseROM 350 to store the repair data corresponding to each defective memory wrapper in the memory data storage 354 of the fuseROM 350. The fuseROM controller 340 copies the repair data from the fuse register 324A of the defective memory wrapper 304 to the memory data storage 354 and erase the fuse register 324A. The BISR controller 345 activates the fuseROM controller 340 to store the bypass data corresponding to each memory wrapper in the memory bypass storage 352 of the fuseROM 350. The fuseROM controller 340 copies the bypass data from the bypass register 326A of memory wrapper 304 to the memory bypass storage 352 and erases the bypass register 326A.

The memory bypass chain 334 links the fuseROM controller 340 to the bypass register 326A. The memory bypass storage 352 stores a bypass data corresponding to each memory wrapper of the plurality of memory wrappers 302. The memory bypass storage 352 stores a bypass data corresponding to the memory wrapper 304. When the memory repair system in an integrated circuit (IC) 300 is reset, the fuseROM controller 340 loads the bypass data from the memory bypass storage 352 in the bypass register 326A. The bypass data in the bypass register 326A indicates if the memory wrapper 304 is defective. The memory data chain 332 links the fuseROM controller 340 to the fuse register 324A through the first multiplexer 330A. The memory data storage 354 stores a repair data corresponding to each defective memory wrapper. The memory data storage 354 stores a repair data corresponding to the memory wrapper 304 if the bypass data in the bypass register 326A indicates that the memory wrapper 304 is defective. In one embodiment, the index value is a set of bits predefined in the IC 300.When the bypass data in the bypass register 326A is equal to an index value; the memory wrapper 304 is defective. The BISR controller 345 activates a BISR selection signal 333 to select the memory data chain 332. The memory clock 336 is used to clock the fuse register 324A in response to the bypass data in the bypass register 326A. The clock-gate 327A is activated to provide memory clock 336 to the fuse register 324A when the bypass data in the bypass register 326A indicates that the memory wrapper 304 is defective. In response to the BISR selection signal 333, the first multiplexer 330A generates a first mux output which is the repair data on the memory data chain 332 from the fuseROM controller 340. The repair data is stored in the fuse register 324A.

The repair data on the memory data chain 332 is provided to the flip-flop 328A that generates a flip-flop signal. The flip-flop signal is the same as the repair data on the memory data chain 332 as the function of the flip-flop 328A is just to add delay to the repair data by a predefined time period. The flip-flop 328A provides ease of timing closure to the memory repair system illustrated in Fig. 3. The flip-flop 328A provides an ability to absorb the process variation margins introduced in the integrated circuit 300 without significant additional costs. In one embodiment, the memory wrappers 304 and 306 in the integrated circuit 300 are implemented without flip-flops 328A and 328B respectively. The second multiplexer 329A receives the flip-flop signal from the flip-flop 328A and a fuse register signal from the fuse register 324A. The second multiplexer 329A generates an output signal in response to the bypass data in the bypass register 326A. When the bypass data in the bypass register 326A is equal to the index value i.e. when the memory wrapper 304 is defective, the output signal of the second multiplexer 329A is the fuse register signal. When the bypass data in the bypass register 326A is not equal to the index value i.e. the memory wrapper 304 is non-defective, the clock-gate 327A is inactivated. As a result, the memory clock 336 is not provided to the fuse register 324A, thus inactivating the fuse register 324A. In this case, the output signal of the second multiplexer 329A is the flip-flop signal or the repair data on the memory data chain 332. Thus, when the memory wrapper 304 is non-defective, the repair data on the memory data chain 332 is directly sent as the output signal thus bypassing the fuse register 324A in the memory wrapper 304. This reduces the activation time of the integrated circuit 300 as the memory wrappers that are non-defective are kept out of the memory data chain 332 used for repairing the plurality of memory wrappers 302. The output signal of the second multiplexer 329A is provided on the memory data chain 332. Thus, when the fuseROM controller 340 loads the repair data on the memory data chain 332, the repair data is shifted on the memory data chain 332 to be loaded in the fuse register of each defective memory wrapper whereas the fuse register of each non-defective memory wrapper is bypassed. The flip-flop 328A prevents combinational feed-through path from the input point of memory data chain 332 in the memory wrapper 304 to the point of output signal generation in the memory wrapper 304.

The operation of the circuit (illustrated in FIG. 3) after self repair by BISR controller 345 is explained now. The memory bypass storage 352 stores a bypass data corresponding to each memory wrapper of the plurality of memory wrappers 302. The fuseROM controller 340 loads the bypass data in the memory bypass chain 334. The bypass data indicates a defective memory wrapper. The fuseROM controller 340 loads the bypass data stored in the memory bypass storage 352 in the corresponding bypass register of each memory wrapper. In one embodiment, the size of bypass register is one bit. In one embodiment, the fuseROM controller 340 maintains a look-up table of bypass data location in the memory bypass storage 352 corresponding to the bypass register in each of the plurality of memory wrappers 302. The memory data storage 354 stores a repair data corresponding to each defective memory wrapper. The memory data chain 332 links the fuse registers in the plurality of memory wrappers 302 with the fuseROM controller 340. The memory data chain 332 is re-configured to link the fuse registers in a set of defective memory wrappers responsive to the bypass data loaded in the memory bypass chain 334. In one embodiment, the defective memory wrappers are activated in response to the bypass data loaded in the bypass register of each memory wrapper and the memory data chain loads the repair data corresponding to each defective memory wrapper in the fuse registers of the defective memory wrappers. The provision of storing repair data only for the set of defective memory wrappers allows reduction in fuseROM 350 area required for memory repair.

The memory data chain 332 is connected to the fuse registers 324A and 324B in a daisy chain fashion. Similarly, the memory bypass chain 334 is connected to the bypass registers 326A and 326B in a daisy chain fashion. In one embodiment, the memory data chain 332 and the memory bypass chain 334 are connected in one to one fashion with the respective registers. In another embodiment, the memory data chain 332 and the memory bypass chain 334 are connected to the respective registers for optimum performance of the memory repair system on the IC 300. The memory bypass chain 334 and the memory data chain 332 may be multiplexed over a single physical pin of the fuseROM controller 340. In one embodiment, the fuseROM controller 340 reads the memory bypass storage 352 of the fuseROM 350 and shifts the bypass data in the memory bypass chain 334. The bypass data gets loaded in the bypass registers of the respective memory wrappers. Once the entire bypass data is shifted into the bypass registers, the memory data chain is re-configured to link only the set of defective memory wrappers. The repair data corresponding to the set of defective memory wrappers is then shifted in the memory data chain 332 by the fuseROM controller 340. The fact that the memory data chain 332 is reconfigured to link only the set of defective memory wrappers allows reduction in activation time of the integrated circuit 300. The fuseROM controller 340 loads the repair data in the corresponding fuse register of each defective memory wrapper. In one embodiment, the fuseROM controller 340 maintains a lookup-table of repair data location in the memory data storage 354 corresponding to a fuse register in a defective memory wrapper of the set of defective memory wrappers. In addition, storing repair data only for the set of defective memory wrappers allows reduction in fuseROM 350 area required for repairing the plurality of memory wrapper 302. The concept of increment repair of the plurality of memory wrappers illustrated in Fig. 2(a) and Fig. 2(b) is applicable to the IC 300 as well.

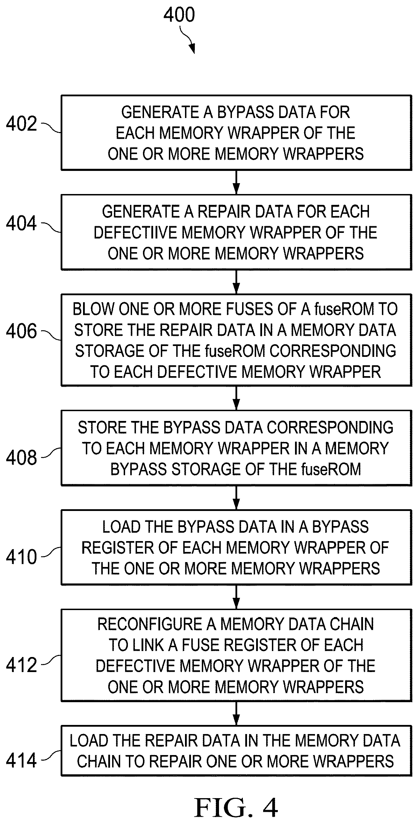

FIG. 4 is a flow diagram 400 illustrating a memory repair system for testing one or more memory wrappers on the integrated circuit 300, according to an embodiment. At step 402, a bypass data is generated for each memory wrapper of the one or more memory wrappers. The bypass data is configured to indicate if a memory wrapper is defective. At step 404, a repair data is generated corresponding to each defective memory wrapper of the one or more memory wrappers. At step 406, one or more fuses of a fuseROM are blown to store the repair data in a memory data storage of the fuseROM corresponding to each defective memory wrapper. At step 408, the bypass data corresponding to each memory wrapper is stored in a memory bypass storage of the fuseROM. The bypass data is loaded in a bypass register of each memory wrapper of the one or more memory wrappers at step 410. A memory data chain is configured to link the fuse registers in each memory wrapper of the one or more memory wrappers. At step 412, the memory data chain is reconfigured to link the fuse register of each defective memory wrapper of the one or more memory wrappers in response to the bypass data loaded in the bypass registers of the one or more memory wrappers. The repair data is loaded in the memory data chain to repair one or more memory wrappers at step 414.

Those skilled in the art will appreciate that modifications may be made to the described embodiments, and also that many other embodiments are possible, within the scope of the claimed invention.

## Claims

1. An integrated circuit configured to reduce repair data load time, comprising:
a plurality of memory wrappers (102), each memory wrapper (104, 106, 108, 110, 112, 114) comprises a memory block (M0, M1, ...) with a fuse register (124A-F) and a bypass register (126A-F), the bypass register (126A-F) configured to receive bypass data;
a fuse ROM store (150) comprising repair data identifying defective elements in the memory blocks (M0, M1, ...) and the bypass data, the bypass data configured to indicate whether to bypass loading of repair data to the fuse register (124A-F) of the memory wrapper (102) wherein said bypass register (126A-F) is located;
a fuseROM controller (140) coupled to the plurality of memory wrappers (102) and configured to load the bypass data into the corresponding bypass register (126A-F) of each of the plurality of memory wrappers (102) and to load the repair data in a corresponding fuse register (124A-F) of each defective memory wrapper;
a memory bypass chain (134) configured to link the bypass registers (126A-F) in the plurality of memory wrappers (102) with the fuseROM controller (140) in daisy chain fashion, wherein the fuseROM controller (140) is configured to load the bypass data from the fuse ROM store (150) via the memory bypass chain (134) into each bypass register (126A-F); and
a memory data chain (136) configured to link the fuse registers (124A-F) in the plurality of memory wrappers with the fuseROM controller (140) in daisy chain fashion, wherein the memory data chain (136) is configured to link the fuse registers (124A-F) in a set of memory wrappers of the plurality of memory wrappers (102) responsive to the bypass data loaded in the memory bypass chain (136), wherein the memory data chain (136) is configured on the basis of the bypass data in between transferring repair data via the fuse register (124A-F) of each defective memory wrapper or bypassing the fuse register (124A-F) of each non-defective memory wrapper; and
wherein the loading of repair data in a non-defective memory wrapper is omitted according to the bypass data stored in the bypass register (126A-F) of the memory wrapper when the bypass data indicates that the memory wrapper is not defective, and repair data in a defective memory wrapper is loaded according to the bypass data stored in the bypass register (126A-F) of each defective memory wrapper when the bypass data indicates that the memory wrapper is defective.

2. The integrated circuit of claim 1, wherein the fuseROM store (150) comprises a memory data storage configured to store a repair data corresponding to each defective memory wrapper and a memory bypass storage configured to store the bypass data corresponding to each memory wrapper.

3. The integrated circuit of claim 2, wherein the memory data storage is configured to store the repair data corresponding to each defective memory wrapper such that a fuseROM store (150) area is reduced.

4. The integrated circuit of claim 1, wherein the self repair of each memory wrapper (104, 106, 108, 110, 112, 114) requires a BISR controller (345) to:
generate the bypass data for each memory wrapper (104, 106, 108, 110, 112, 114) of the plurality of memory wrappers (102) and store the bypass data in the corresponding bypass register (126A-F) of each memory wrapper (104, 106, 108, 110, 112, 114);
generate the repair data for each defective memory wrapper and store the repair data in the corresponding fuse register (124A-F) of the defective memory wrapper;
activate the fuseROM controller (140) to blow one or more fuses of the fuseROM store (150) to store the repair data corresponding to each defective memory wrapper in the memory data storage of the fuseROM store (150) and erase the fuse register (124A-F) of each defective memory wrapper; and
activate the fuseROM controller (140) to store the bypass data corresponding to each memory wrapper (104, 106, 108, 110, 112, 114) in the memory bypass storage of the fuseROM store (150) and erase the bypass register (126A-F) of each memory wrapper (104, 106, 108, 110, 112, 114).

5. The integrated circuit of claim 1, wherein the memory wrapper further comprises:
a first multiplexer (330A, 330B) configured to receive the repair data from the fuseROM controller (140) and the repair data from the BISR controller (345) and configured to generate a first mux output in response to a BISR selection signal, wherein the first mux output is the repair data from the BISR controller (345) during self repair of the memory wrapper;
a clock-gate (327A, 327B) configured to provide a memory clock to the fuse register (124A-F) when the bypass data in the bypass register (126A-F) is equal to an index value, wherein the fuse register (124A-F) is configured to receive the first mux output and generate a fuse register signal, and wherein the memory wrapper is defective when the bypass data in the bypass register (126A-F) is equal to the index value; and
a second multiplexer (329A, 329B) configured to receive the first mux output and the fuse register signal to generate an output signal in response to the bypass data in the bypass register (126A-F), wherein the output signal is the fuse register signal when the bypass data in the bypass register (126A-F) is equal to an index value and the output signal is the repair data when the bypass data in the bypass register (126A-F) is not equal to the index value.

6. A method of repairing one or more memory wrappers (102) on an integrated circuit, each memory wrapper (104, 106, 108, 110, 112, 114) comprises a memory block (M0, M1, ...) with a fuse register (124A-F) and a bypass register (126A-F), the bypass register (126A-F) receives bypass data, the method comprising:
storing bypass data corresponding to each memory wrapper (104, 106, 108, 110, 112, 114) of the one or more memory wrappers (102) in a memory bypass storage, wherein the bypass data is configured to indicate a defective memory wrapper of the one or more memory wrappers (102);
storing repair data which identify defective elements in the memory blocks (M0, M1, ...) and the bypass data, the bypass data indicate whether to bypass loading of repair data to the fuse register (124A-F) of the memory wrapper wherein said bypass register (126A-F) is located;
loading the bypass data into the corresponding bypass register (126A-F) of each of the plurality of memory wrappers (102) and loading the repair data in a corresponding fuse register (124A-F) of each defective memory wrapper;
loading the bypass data in a memory bypass chain (134), wherein the memory bypass chain (134) is configured to link the bypass register (126A-F) in the plurality of memory wrappers (102) with a fuseROM controller (140) in daisy chain fashion, wherein the fuseROM controller (140) is configured to load the bypass data from a fuse ROM store (150) via the memory bypass chain (134) into each bypass register (126A-F) ; and
loading the repair data in a memory data chain (136) configured to link the fuse registers (124A-F) in the plurality of memory wrappers (102) with the fuseROM controller (140) in daisy chain fashion, wherein the memory data chain (136) is configured to link the fuse registers (124A-F) in a set of memory wrappers of the plurality of memory wrappers (102) responsive to the bypass data loaded in the memory bypass chain (134), wherein the memory data chain (136) is configured on the basis of the bypass data in between transferring repair data via the fuse register (124A-F) of each defective memory wrapper or bypassing the fuse register (124A-F) of each non-defective memory wrapper; and
wherein the loading of repair data in a non-defective memory wrapper is omitted according to the bypass data stored in the bypass register (126A-F) of the memory wrapper when the bypass data indicates that the memory wrapper is not defective, and repair data in a defective memory wrapper is loaded according to the bypass data stored in the bypass register (124A-F) of each defective memory wrapper when the bypass data indicates that the memory wrapper is defective.

7. The method of claim 6, wherein loading the repair data in a memory data chain (136) further comprising configuring the memory data chain (136) to link each memory wrapper of the one or more memory wrapper (102) and re-configuring the memory data chain to link each defective memory wrapper of the one or more memory wrappers (102) responsive to the bypass data loaded in the memory bypass chain (134) such that an activation time of the integrated circuit is reduced.

8. The method of claim 6, further comprising activating a defective memory wrapper responsive to the bypass data in the bypass register (126A-F) of each memory wrapper and configuring the memory data chain (136) to load a repair data corresponding to the defective memory wrapper in a fuse register (124A-F) of the defective memory wrapper.

9. The method of claim 8, wherein activating the defective memory wrapper further comprises:
comparing the bypass data in the bypass register (126A-F) and an index value;
providing a memory clock to the fuse register (124A-F) when the bypass data in the bypass register (126A-F) is equal to the index value, wherein the memory wrapper is defective when the bypass data in the bypass register (126A-F) is equal to the index value;
loading the repair data on the memory data chain (136) in the fuse register (124A-F) of the defective memory wrapper to generate a fuse register signal; and
multiplexing the repair data and the fuse register signal to generate an output signal in response to the bypass data in the bypass register (126A-F).

10. The method of claim 9, further comprising multiplexing a flip-flop signal and the fuse register signal to generate the output signal, wherein the flip-flop signal is generated from the repair data.

## Patentansprüche

1. Integrierte Schaltung, die dazu konfiguriert ist, eine Reparaturdatenladezeit zu reduzieren, umfassend:
mehrere Speicherwrapper (102), wobei jeder Speicherwrapper (104, 106, 108, 110, 112, 114) einen Speicherblock (M0, M1, ...) mit einem Sicherungsregister (124A-F) und einem Bypassregister (126A-F) umfasst, wobei das Bypassregister (126A-F) dazu konfiguriert ist, Bypassdaten zu empfangen;
einen Sicherungs-ROM-Speicher (150), der Reparaturdaten, die fehlerhafte Elemente in den Speicherblöcken (M0, M1, ...) identifizieren, und die Bypassdaten umfasst, wobei die Bypassdaten dazu konfiguriert sind, anzugeben, ob ein Laden von Reparaturdaten in das Sicherungsregister (124A-F) des Speicherwrappers (102), in dem sich das Bypassregister (126A-F) befindet, umgangen werden soll;
eine Sicherungs-ROM-Steuerung (140), die mit den mehreren Speicherwrappern (102) gekoppelt und dazu konfiguriert ist, die Bypassdaten in das entsprechende Bypassregister (126A-F) jedes der mehreren Speicherwrapper (102) zu laden und die Reparaturdaten in ein entsprechendes Sicherungsregister (124A-F) jedes fehlerhaften Speicherwrappers zu laden;
eine Speicherbypasskette (134), die dazu konfiguriert ist, die Bypassregister (126A-F) in den mehreren Speicherwrappern (102) mit der Sicherungs-ROM-Steuerung (140) auf Daisy-Chain-Weise zu verknüpfen, wobei die Sicherungs-ROM-Steuerung (140) dazu konfiguriert ist, die Bypassdaten aus dem Sicherungs-ROM-Speicher (150) über die Speicherbypasskette (134) in jedes Bypassregister (126A-F) zu laden; und
eine Speicherdatenkette (136), die dazu konfiguriert ist, die Sicherungsregister (124A-F) in den mehreren Speicherwrappern mit der Sicherungs-ROM-Steuerung (140) auf Daisy-Chain-Weise zu verknüpfen, wobei die Speicherdatenkette (136) dazu konfiguriert ist, die Sicherungsregister (124A-F) in einem Satz von Speicherwrappern der mehreren Speicherwrapper (102) als Reaktion auf die in die Speicherbypasskette (136) geladenen Bypassdaten zu verknüpfen, wobei die Speicherdatenkette (136) basierend auf den Bypassdaten zwischen einem Übertragen von Reparaturdaten über das Sicherungsregister (124A-F) jedes fehlerhaften Speicherwrappers oder einem Umgehen des Sicherungsregisters (124A-F) jedes nicht fehlerhaften Speicherwrappers konfiguriert ist; und
wobei das Laden von Reparaturdaten in einen nicht fehlerhaften Speicherwrapper gemäß den in dem Bypassregister (126A-F) des Speicherwrappers gespeicherten Bypassdaten ausgelassen wird, wenn die Bypassdaten angeben, dass der Speicherwrapper nicht fehlerhaft ist, und Reparaturdaten in einem fehlerhaften Speicherwrapper gemäß den in dem Bypassregister (126A-F) jedes fehlerhaften Speicherwrappers gespeicherten Bypassdaten geladen werden, wenn die Bypassdaten angeben, dass der Speicherwrapper fehlerhaft ist.

2. Integrierte Schaltung nach Anspruch 1, wobei der Sicherungs-ROM-Speicher (150) einen Speicherdatenspeicher, der dazu konfiguriert ist, jedem fehlerhaften Speicherwrapper entsprechende Reparaturdaten zu speichern, und einen Speicherbypassspeicher, der dazu konfiguriert ist, die jedem Speicherwrapper entsprechenden Bypassdaten zu speichern, umfasst.

3. Integrierte Schaltung nach Anspruch 2, wobei der Speicherdatenspeicher dazu konfiguriert ist, die jedem fehlerhaften Speicherwrapper entsprechenden Reparaturdaten so zu speichern, dass ein Sicherungs-ROM-Speicher(150)-Bereich reduziert wird.

4. Integrierte Schaltung nach Anspruch 1, wobei die Selbstreparatur jedes Speicherwrappers (104, 106, 108, 110, 112, 114) eine BISR-Steuerung (345) zu Folgendem erfordert:
Erzeugen der Bypassdaten für jeden Speicherwrapper (104, 106, 108, 110, 112, 114) der mehreren Speicherwrapper (102) und Speichern der Bypassdaten in dem entsprechenden Bypassregister (126A-F) jedes Speicherwrappers (104, 106, 108, 110, 112, 114); Erzeugen der Reparaturdaten für jeden fehlerhaften Speicherwrapper und Speichern der Reparaturdaten in dem entsprechenden Sicherungsregister (124A-F) des fehlerhaften Speicherwrappers;
Aktivieren der Sicherungs-ROM-Steuerung (140), um eine oder mehrere Sicherungen des Sicherungs-ROM-Speichers (150) auszulösen, um die jedem fehlerhaften Speicherwrapper entsprechenden Reparaturdaten in dem Speicherdatenspeicher des Sicherungs-ROM-Speichers (150) zu speichern, und Löschen des Sicherungsregisters (124A-F) jedes fehlerhaften Speicherwrappers; und
Aktivieren der Sicherungs-ROM-Steuerung (140), um die jedem Speicherwrapper (104, 106, 108, 110, 112, 114) entsprechenden Bypassdaten in dem Speicherbypassspeicher des Sicherungs-ROM-Speichers (150) zu speichern, und Löschen des Bypassregisters (126A-F) jedes Speicherwrappers ((104, 106, 108, 110, 112, 114).

5. Integrierte Schaltung nach Anspruch 1, wobei der Speicherwrapper ferner Folgendes umfasst:
einen ersten Multiplexer (330A, 330B), der dazu konfiguriert ist, die Reparaturdaten von der Sicherungs-ROM-Steuerung (140) und die Reparaturdaten von der BISR-Steuerung (345) zu empfangen, und dazu konfiguriert ist, eine erste mux-Ausgabe als Reaktion auf ein BISR-Auswahlsignal zu erzeugen, wobei die erste mux-Ausgabe die Reparaturdaten von der BISR-Steuerung (345) während einer Selbstreparatur des Speicherwrappers ist;
ein Taktgatter (327A, 327B), das dazu konfiguriert ist, dem Sicherungsregister (124A-F) einen Speichertakt bereitzustellen, wenn die Bypassdaten in dem Bypassregister (126A-F) gleich einem Indexwert sind, wobei das Sicherungsregister (124A-F) dazu konfiguriert ist, die erste mux-Ausgabe zu empfangen und ein Sicherungsregistersignal zu erzeugen, und wobei der Speicherwrapper fehlerhaft ist, wenn die Bypassdaten in dem Bypassregister (126A-F) gleich dem Indexwert sind; und
einen zweiten Multiplexer (329A, 329B), der dazu konfiguriert ist, die erste mux-Ausgabe und das Sicherungsregistersignal zu empfangen, um ein Ausgabesignal als Reaktion auf die Bypassdaten in dem Bypassregister (126A-F) zu erzeugen, wobei das Ausgabesignal das Sicherungsregistersignal ist, wenn die Bypassdaten in dem Bypassregister (126A-F) gleich einem Indexwert sind, und das Ausgabesignal die Reparaturdaten ist, wenn die Bypassdaten in dem Bypassregister (126A-F) nicht gleich dem Indexwert sind.

6. Verfahren zum Reparieren eines oder mehrerer Speicherwrapper (102) auf einer integrierten Schaltung, wobei jeder Speicherwrapper (104, 106, 108, 110, 112, 114) einen Speicherblock (M0, M1, ...) mit einem Sicherungsregister (124A-F) und einem Bypassregister (126A-F) umfasst, wobei das Bypassregister (126A-F) Bypassdaten empfängt, wobei das Verfahren Folgendes umfasst:
Speichern von jedem Speicherwrapper (104, 106, 108, 110, 112, 114) des einen oder der mehreren Speicherwrapper (102) entsprechenden Bypassdaten in einem Speicherbypassspeicher, wobei die Bypassdaten dazu konfiguriert sind, einen fehlerhaften Speicherwrapper des einen oder der mehreren Speicherwrapper (102) anzugeben;
Speichern von Reparaturdaten, die fehlerhafte Elemente in den Speicherblöcken (M0, M1, ...) identifizieren, und der Bypassdaten, wobei die Bypassdaten angeben, ob ein Laden von Reparaturdaten in das Sicherungsregister (124A-F) des Speicherwrappers, in dem sich das Bypassregister (126A-F) befindet, umgangen werden soll; Laden der Bypassdaten in das entsprechende Bypassregister (126A-F) jedes der mehreren Speicherwrapper (102) und Laden der Reparaturdaten in ein entsprechendes Sicherungsregister (124A-F) jedes fehlerhaften Speicherwrappers;
Laden der Bypassdaten in eine Speicherbypasskette (134), wobei die Speicherbypasskette (134) dazu konfiguriert ist, das Bypassregister (126A-F) in den mehreren Speicherwrappern (102) mit einer Sicherungs-ROM-Steuerung (140) auf Daisy-Chain-Weise zu verknüpfen, wobei die Sicherungs-ROM-Steuerung (140) dazu konfiguriert ist, die Bypassdaten aus einem Sicherungs-ROM-Speicher (150) über die Speicherbypasskette (134) in jedes Bypassregister (126A-F) zu laden; und
Laden der Reparaturdaten in eine Speicherdatenkette (136), die dazu konfiguriert ist, die Sicherungsregister (124A-F) in den mehreren Speicherwrappern (102) mit der Sicherungs-ROM-Steuerung (140) auf Daisy-Chain-Weise zu verknüpfen, wobei die Speicherdatenkette (136) dazu konfiguriert ist, die Sicherungsregister (124A-F) in einem Satz von Speicherwrappern der mehreren Speicherwrapper (102) als Reaktion auf die in die Speicherbypasskette (134) geladenen Bypassdaten zu verknüpfen, wobei die Speicherdatenkette (136) basierend auf den Bypassdaten zwischen einem Übertragen von Reparaturdaten über das Sicherungsregister (124A-F) jedes fehlerhaften Speicherwrappers oder einem Umgehen des Sicherungsregisters (124A-F) jedes nicht fehlerhaften Speicherwrappers konfiguriert ist; und
wobei das Laden von Reparaturdaten in einen nicht fehlerhaften Speicherwrapper gemäß den in dem Bypassregister (126A-F) des Speicherwrappers gespeicherten Bypassdaten ausgelassen wird, wenn die Bypassdaten angeben, dass der Speicherwrapper nicht fehlerhaft ist, und Reparaturdaten in einem fehlerhaften Speicherwrapper gemäß den in dem Bypassregister (124A-F) jedes fehlerhaften Speicherwrappers gespeicherten Bypassdaten geladen werden, wenn die Bypassdaten angeben, dass der Speicherwrapper fehlerhaft ist.

7. Verfahren nach Anspruch 6, wobei das Laden der Reparaturdaten in eine Speicherdatenkette (136) ferner Konfigurieren der Speicherdatenkette (136) zum Verknüpfen jedes Speicherwrappers des einen oder der mehreren Speicherwrapper (102) und Neukonfigurieren der Speicherdatenkette zum Verknüpfen jedes fehlerhaften Speicherwrappers des einen oder der mehreren Speicherwrapper (102) als Reaktion auf die in die Speicherbypasskette (134) geladenen Bypassdaten umfasst, so dass eine Aktivierungszeit der integrierten Schaltung reduziert wird.

8. Verfahren nach Anspruch 6, ferner umfassend Aktivieren eines fehlerhaften Speicherwrappers als Reaktion auf die Bypassdaten in dem Bypassregister (126A-F) jedes Speicherwrappers und Konfigurieren der Speicherdatenkette (136) zum Laden von dem fehlerhaften Speicherwrapper entsprechenden Reparaturdaten in ein Sicherungsregister (124A-F) des fehlerhaften Speicherwrappers.

9. Verfahren nach Anspruch 8, wobei das Aktivieren des fehlerhaften Speicherwrappers ferner Folgendes umfasst:
Vergleichen der Bypassdaten in dem Bypassregister (126A-F) und eines Indexwerts;
Bereitstellen eines Speichertakts für das Sicherungsregister (124A-F), wenn die Bypassdaten in dem Bypassregister (126A-F) gleich dem Indexwert sind, wobei der Speicherwrapper fehlerhaft ist, wenn die Bypassdaten in dem Bypassregister (126A-F) gleich dem Indexwert sind;
Laden der Reparaturdaten auf der Speicherdatenkette (136) in das Sicherungsregister (124A-F) des fehlerhaften Speicherwrappers, um ein Sicherungsregistersignal zu erzeugen; und
Multiplexen der Reparaturdaten und des Sicherungsregistersignals als Reaktion auf die Bypassdaten in dem Bypassregister (126A-F), um ein Ausgabesignal zu erzeugen.

10. Verfahren nach Anspruch 9, ferner umfassend Multiplexen eines Flip-Flop-Signals und des Sicherungsregistersignals, um das Ausgabesignal zu erzeugen, wobei das Flip-Flop-Signal aus den Reparaturdaten erzeugt wird.

## Revendications

1. Circuit intégré configuré pour réduire le temps de chargement de données de réparation, le circuit comprenant :
une pluralité de blocs d'interface mémoire (102), chaque bloc d'interface mémoire (104, 106, 108, 110, 112, 114) comprenant un bloc mémoire (M0, M1, ...) avec un registre de fusibles (124A-F) et un registre de contournement (126A-F), le registre de contournement (126A-F) étant configuré pour recevoir des données de contournement ;
une mémoire ROM de fusibles (150) comprenant des données de réparation identifiant des éléments défectueux dans les blocs mémoire (M0, M1, ...) et les données de contournement, les données de contournement étant configurées pour indiquer s'il convient de contourner le chargement de données de réparation dans le registre de fusibles (124A-F) du bloc d'interface mémoire (102) où ledit registre de contournement (126A-F) est situé ;
un contrôleur de ROM de fusibles (140) couplé à la pluralité de blocs d'interface mémoire (102) et configuré pour charger les données de contournement dans le registre de contournement correspondant (126A-F) de chacun de la pluralité de blocs d'interface mémoire (102) et pour charger les données de réparation dans un registre de fusibles correspondant (124A-F) de chaque bloc d'interface mémoire défectueux ;
une chaîne de contournement mémoire (134) configurée pour relier les registres de contournement (126A-F) dans la pluralité de blocs d'interface mémoire (102) avec le contrôleur de ROM de fusibles (140) en série, le contrôleur de ROM de fusibles (140) étant configuré pour charger les données de contournement de la mémoire ROM de fusibles (150) par l'intermédiaire de la chaîne de contournement mémoire (134) dans chaque registre de contournement (126A-F) ; et
une chaîne de données mémoire (136) configurée pour relier les registres de fusibles (124A-F) de la pluralité de blocs d'interface mémoire au contrôleur de ROM de fusibles (140) en guirlande, où la chaîne de données mémoire (136) est configurée pour relier les registres de fusibles (124A-F) dans un ensemble de blocs d'interface mémoire de la pluralité de blocs d'interface mémoire (102) en réponse aux données de contournement chargées dans la chaîne de contournement mémoire (136), où la chaîne de données mémoire (136) est configurée sur la base des données de contournement entre le transfert de données de réparation par l'intermédiaire du registre de fusibles (124A-F) de chaque bloc d'interface mémoire défectueux ou le contournement du registre de fusibles (124A-F) de chaque bloc d'interface mémoire non défectueux ; et
où le chargement de données de réparation dans un bloc d'interface mémoire non défectueux est omis en fonction des données de contournement stockées dans le registre de contournement (126A-F) du bloc d'interface mémoire lorsque les données de contournement indiquent que le bloc d'interface mémoire n'est pas défectueux, et les données de réparation dans un bloc d'interface mémoire défectueux sont chargées en fonction des données de contournement stockées dans le registre de contournement (126A-F) de chaque bloc d'interface mémoire défectueux lorsque les données de contournement indiquent que le bloc d'interface mémoire est défectueux.

2. Circuit intégré selon la revendication 1, dans lequel la mémoire ROM de fusibles (150) comprend une mémoire de stockage de données configurée pour stocker des données de réparation correspondant à chaque bloc d'interface mémoire défectueux et une mémoire de stockage de contournement de mémoire configurée pour stocker les données de contournement correspondant à chaque bloc d'interface mémoire.

3. Circuit intégré selon la revendication 2, dans lequel la mémoire de stockage de données de mémoire est configurée pour stocker les données de réparation correspondant à chaque bloc d'interface mémoire défectueux de sorte qu'une zone de stockage de ROM de fusibles (150) soit réduite.

4. Circuit intégré selon la revendication 1, dans lequel l'auto-réparation de chaque bloc d'interface de mémoire (104, 106, 108, 110, 112, 114) nécessite un contrôleur BISR (345) pour :
générer les données de contournement pour chaque bloc d'interface mémoire (104, 106, 108, 110, 112, 114) de la pluralité de blocs d'interface mémoire (102) et stocker les données de contournement dans le registre de contournement correspondant (126A-F) de chaque bloc d'interface mémoire (104, 106, 108, 110, 112, 114) ;
générer les données de réparation pour chaque bloc d'interface mémoire défectueux et stocker les données de réparation dans le registre de fusibles correspondant (124A-F) du bloc d'interface mémoire défectueux ;
activer le contrôleur de ROM de fusibles (140) pour faire sauter un ou plusieurs fusibles de la mémoire de ROM de fusibles (150) afin de stocker les données de réparation correspondant à chaque bloc d'interface mémoire défectueux dans la mémoire de stockage de données de mémoire de la mémoire ROM de fusibles (150) et effacer le registre de fusibles (124A-F) de chaque bloc d'interface mémoire défectueux ; et
activer le contrôleur de ROM de fusibles (140) pour stocker les données de contournement correspondant à chaque bloc d'interface mémoire (104, 106, 108, 110, 112, 114) dans la mémoire de stockage de contournement de la mémoire ROM de fusibles (150) et effacer le registre de contournement (126A-F) de chaque bloc d'interface mémoire (104, 106, 108, 110, 112, 114).

5. Circuit intégré selon la revendication 1, dans lequel le bloc d'interface mémoire comprend en outre :
un premier multiplexeur (330A, 330B) configuré pour recevoir les données de réparation depuis le contrôleur de ROM de fusibles (140) et les données de réparation depuis le contrôleur BISR (345), et configuré pour générer une première sortie mutiplex en réponse à un signal de sélection BISR, la première sortie mutiplex étant constituée des données de réparation provenant du contrôleur BISR (345) pendant l'auto-réparation du bloc d'interface mémoire ;
une porte d'horloge (327A, 327B) configurée pour fournir une horloge mémoire au registre de fusibles (124A-F) lorsque les données de contournement dans le registre de contournement (126A-F) sont égales à une valeur d'index, le registre de fusibles (124A-F) étant configuré pour recevoir la première sortie mutiplex et générer un signal de registre de fusibles, et où le bloc d'interface mémoire est défectueux lorsque les données de contournement dans le registre de contournement (126A-F) sont égales à la valeur d'index ; et
un deuxième multiplexeur (329A, 329B) configuré pour recevoir la première sortie mutiplex et le signal de registre de fusibles pour générer un signal de sortie en réponse aux données de contournement dans le registre de contournement (126A-F), où le signal de sortie est le signal de registre de fusibles lorsque les données de contournement dans le registre de contournement (126A-F) sont égales à une valeur d'index et le signal de sortie comprend les données de réparation lorsque les données de contournement dans le registre de contournement (126A-F) ne sont pas égales à la valeur d'index.

6. Procédé de réparation d'un ou plusieurs blocs d'interface mémoire (102) sur un circuit intégré, chaque bloc d'interface mémoire (104, 106, 108, 110, 112, 114) comprenant un bloc mémoire (M0, M1, ...) ayant un registre de fusibles (124A-F) et un registre de contournement (126A-F), le registre de contournement (126A-F) recevant des données de contournement, le procédé comprenant les étapes suivantes :
stocker des données de contournement correspondant à chaque bloc d'interface mémoire (104, 106, 108, 110, 112, 114) des un ou plusieurs blocs d'interface mémoire (102) dans une mémoire de stockage de contournement de mémoire, où les données de contournement sont configurées pour indiquer un bloc d'interface mémoire défectueux des un ou plusieurs blocs d'interface mémoire (102) ;
stocker des données de réparation qui identifient des éléments défectueux dans les blocs mémoire (M0, M1, ...) et les données de contournement, les données de contournement étant indicatives du fait qu'il faille ou non contourner le chargement de données de réparation dans le registre de fusibles (124A-F) du bloc d'interface mémoire dans lequel se trouve ledit registre de contournement (126A-F) ;
charger les données de contournement dans le registre de contournement correspondant (126A-F) de chacun de la pluralité de blocs d'interface mémoire (102) et charger les données de réparation dans un registre de fusibles correspondant (124A-F) de chaque bloc d'interface mémoire défectueux ;
charger les données de contournement dans une chaîne de contournement de mémoire (134), la chaîne de contournement de mémoire (134) étant configurée pour relier le registre de contournement (126A-F) dans la pluralité de blocs d'interface mémoire (102) à un contrôleur de ROM de fusibles (140) en guirlande, le contrôleur de ROM de fusibles (140) étant configuré pour charger les données de contournement d'une mémoire de stockage de ROM de fusibles (150) par l'intermédiaire de la chaîne de contournement de mémoire (134) dans chaque registre de contournement (126A-F) ; et
charger les données de réparation dans une chaîne de données mémoire (136) configurée pour relier les registres de fusibles (124A-F) de la pluralité de blocs d'interface mémoire (102) au contrôleur de ROM de fusibles (140) en guirlande, où la chaîne de données mémoire (136) est configurée pour relier les registres de fusibles (124A-F) dans un ensemble de blocs d'interface mémoire de la pluralité de blocs d'interface mémoire (102) en réponse aux données de contournement chargées dans la chaîne de contournement mémoire (134), où la chaîne de données mémoire (136) est configurée sur la base des données de contournement entre le transfert de données de réparation par l'intermédiaire du registre de fusibles (124A-F) de chaque bloc d'interface mémoire défectueux ou le contournement du registre de fusibles (124A-F) de chaque bloc d'interface mémoire non défectueux ; et
où le chargement de données de réparation dans un bloc d'interface mémoire non défectueux est omis en fonction des données de contournement stockées dans le registre de contournement (126A-F) du bloc d'interface mémoire lorsque les données de contournement indiquent que le bloc d'interface mémoire n'est pas défectueux, et les données de réparation dans un bloc d'interface mémoire défectueux sont chargées en fonction des données de contournement stockées dans le registre de contournement (124A-F) de chaque bloc d'interface mémoire défectueux lorsque les données de contournement indiquent que le bloc d'interface mémoire est défectueux.

7. Procédé selon la revendication 6, dans lequel le chargement des données de réparation dans une chaîne de données de mémoire (136) comprend en outre de configurer la chaîne de données de mémoire (136) pour relier chaque bloc d'interface mémoire des un ou plusieurs blocs d'interface mémoire (102) et de reconfigurer la chaîne de données de mémoire pour relier chaque bloc d'interface mémoire défectueux des un ou plusieurs blocs d'interface mémoire (102) en réponse aux données de contournement chargées dans la chaîne de contournement de mémoire (134) de sorte qu'un temps d'activation du circuit intégré soit réduit.

8. Procédé selon la revendication 6, comprenant en outre d'activer un bloc d'interface mémoire défectueux en réponse aux données de contournement dans le registre de contournement (126A-F) de chaque bloc d'interface mémoire et de configurer la chaîne de données de mémoire (136) pour charger des données de réparation correspondant au bloc d'interface mémoire défectueux dans un registre de fusibles (124A-F) du bloc d'interface mémoire défectueux.

9. Procédé selon la revendication 8, dans lequel l'activation du bloc d'interface mémoire défectueux comprend en outre les étapes suivantes :
comparer les données de contournement dans le registre de contournement (126A-F) et une valeur d'index ;
fournir une horloge mémoire au registre de fusibles (124A-F) lorsque les données de contournement dans le registre de contournement (126A-F) sont égales à la valeur d'index, le bloc d'interface mémoire étant défectueux lorsque les données de contournement dans le registre de contournement (126A-F) sont égales à la valeur d'index ;
charger les données de réparation sur la chaîne de données de mémoire (136) dans le registre de fusibles (124A-F) du bloc d'interface mémoire défectueux pour générer un signal de registre de fusible ; et
multiplexer les données de réparation et le signal de registre de fusibles pour générer un signal de sortie en réponse aux données de contournement dans le registre de contournement (126A-F).

10. Procédé selon la revendication 9, comprenant en outre de multiplexer un signal de bascule et le signal de registre de fusibles pour générer le signal de sortie, où le signal de bascule est généré à partir des données de réparation.
